# EUROPEAN PATENT SPECIFICATION

(11) **EP 0 476 322 B1**
(45) Date of publication and mention of the grant of the patent: **17.04.1996**
(21) Application number: 91113862.6
(22) Date of filing: 19.08.1991
(51) Int. Cl.: H05K 7/14

(54) **Casing assembly for electronic equipment.**
Gehäuseanordnung für eine elektronische Anlage
Structure de boîtier pour un équipement électronique

(30) Priority: 10.09.1990 JP 239429/90
(43) Date of publication of application: 25.03.1992
(73) Proprietor: Yokogawa Electric Corporation, Tokyo 180 (JP)
(72) Inventor: Takahashi, Tatsuhiko, Tokyo 181 (JP); Taguchi, Masaaki, Tokorozawa-shi, Saitama, 359 (JP); Murayama, Minoru, Koganei-shi, Tokyo, 184 (JP); Watanabe, Fumio, Koufu-shi, Yamanashi, 400 (JP)
(74) Representative: Henkel, Feiler, Hänzel & Partner

(56) References cited:
- EP-A- 0 145 380
- EP-A- 0 171 687
- FR-A- 2 567 304
- US-A- 4 769 557

## Description

### BACKGROUND OF THE INVENTION

### Field of the Invention

This invention relates to a casing assembly for electronic equipment which is used to accommodate instruments and the like of the rack mount type and more particularly to a structural improvement of the casing assembly.

### Description of the Prior Art

Electronic equipment means, for example, control devices as mounted in machine tools, control panels, etc. Since a casing assembly for such control devices is generally mounted internally, it is desirable that the size be small. In this field, the present applicant filed Japanese Patent Laid-Open No. 1-200699.

To decrease the size of the casing assembly, the following problems must be considered.

### (i) Mounting of DIN rail

A casing assembly for electronic equipment is generally attached to a DIN ( Deutsche Industrie Norm ) rail or a wall body. In this regard, the casing assembly must have a mechanism for attaching it to the DIN rail. This attaching mechanism, however, increases the overall size of the casing assembly, or becomes unnecessary when attaching to the wall body.

### (ii) Heat release

Since electronic equipment includes an exothermic element such as a power source, it is necessary to suppress the internal temperature below a given level by releasing heat. To realize heat release, conventional electronic equipment usually utilizes radiation and convection, not conduction. In the case of radiation and convection associated with the surface of the casing assembly, the release amount of heat is determined by the temperature difference and the surface area of the casing assembly. On the other hand, in the case of convection associated with the heated air inside the casing assembly which is made up of free convection and force convection, the release amount of heat is determined by the opening area of the casing assembly for free convection or by the size and number of fans and the like for forced convection.

If electronic components are densely packaged in a smaller-sized casing assembly without improving the heat release function, since the power of heat release decreases with decreasing size for the same heating value, the internal temperature rises; consequently, the range of surrounding temperatures in which the casing assembly is serviceable is narrowed. On the other hand, if the size of the casing assembly is selected such that a given cooling power is secured, this limits the size reduction of the casing assembly.

### (iii) Supporting of terminal mount and printed board

Conventional printed board is large in size and poor in rigidity and is supported at both edges by guide grooves of the casing assembly and screwed at a central portion. Since the rigidity of the printed board increases relatively as the size decreases, it is desirable to eliminate reinforcing members to thereby decrease the number of such parts.

Where two printed boards are to be used in piled form, one printed board is screwed to the other. In this case, since any electronic components cannot be disposed in such a screwed portion, the packaging density decreases and the work of assembly or screwing is troublesome.

### (iv) Mounting of programmer

Control device is used in conjunction with an input device called "programmer". Depending on the direction of the control device being lateral or longitudinal, the programmer is attached to the control device in the lateral or longitudinal direction. The display direction of a display section ( made of LCD or the like ) provided in the programmer is made to accord with the mounting direction of the programmer relative to the control device. For general purposes, however, it is desirable or convenient for users to make the display of the programmer easy to observe irrespective of the direction in which the control device is mounted.

### (v) Cover and connector

Connector is mounted on the control device and used to connect the programmer. Since the programmer is not always connected, when not in use it is covered with a dust protective cover to guard contact elements. If made detachable, the dust protective cover is liable to be lost. On the other hand, if made slidable or pivotable ( like a door ), the dust protective cover needs a dead space in which the cover can slide or pivot; consequently, the packaging sphere allowed inside the control device decreases and the surface of the casing assembly becomes rugged, thereby degrading appearance.

When the programmer is mounted to the control device, it is connected to the connector by controlling a latch provided on the programmer. This latch serves as a guide and retainer in relation to the connector. However, if any force is applied to the programmer, it is applied through the latch to the connector; consequently, the reliability of connection of the connector is degraded.

### (vi) Attaching of extended module

Extended module is connected to a casing where additional functions are necessary other than the standard functions of a basic module of the casing assembly for electronic equipment. In this case, it is desirable that the casing be made uniform and a joint cable be hidden inside the casing. Since the connection of the extended module is made to only one casing, it is better to simplify a connection mechanism ( for the extended module ) of the casing assembly.

A casing assembly for electronic devices is described in IBM Technical Disclosure Bulletin, Vol. 28, No. 4, September 1985, New York, page 1490, which discloses a printed board on which exothermic electronic components are mounted, a casing for covering the printed board and a base integrally formed with the casing. The base is made from a heat conductive material and a heat conductive flexible plate-like cushioning member made of electrically insulative material is interposed between the printed board and the base so as to be in contact therewith and to release the heat generated within the electronic components through the printed board and the lead wires and the cushioning member and the base to the surrounding air.

### SUMMARY OF THE INVENTION

It is the object of the present invention to provide a small-sized casing assembly for electronic equipment having the function of attaching to a supporting rail, preferably a DIN rail.

According to the invention this object is solved by providing a casing assembly for electronic equipment comprising a printed board on which an exothermic electronic component is mounted, a casing for covering the printed board, and a base for attaching the casing to a rail, wherein the base is made of high heat conductive material and has a planar structure which results in a large contact area between it and the rail, and a high heat conductive plate-like cushioning member made of electrically insulative material is interposed between the printed board and the base in contact with them, whereby the heat generated in the electronic component is released through the printed board and lead wires and through the cushioning member and the base to the rail, wherein said rail has a substantially U-shaped cross section and two flanges, a guide latch member is detachably mounted to the base which comes into engagement with one flange of the rail, and a pressure latch member is detachably mounted to the base which comes into engagement with the other flange of the rail and has a slider coming into resilient and pressure contact with the rail.

According to a second aspect of the present invention the cooling efficiency of the casing assembly should be enhanced so as to suppress the rise of internal temperature so that the electronic equipment can operate at higher surrounding temperatures.

According to a third aspect of the invention the heat release effect of such casing assembly should be enhanced so that components can be densly packaged and the size can be reduced.

According to a fourth aspect of the invention the parts of the electronic equipment should be mountable piled up in one direction so as to facilitate assembling work of the casing assembly.

According to a fifth aspect of the invention the degree of freedom relating to the attaching direction of a programmer on such casing assembly should be enhanced, thus facilitating handling thereof.

In a preferred embodiment of a casing assembly according to the invention,

to accomplish the second and third aspects, the base is made of high heat conductive material and has a planar structure which results in a large contact area between it and the rail, and a high heat conductive and flexible plate-like cushioning member made of electrically insulative material is interposed between the printed board and the base in contact with them. Preferably the thickness of the cushioning member is larger than the length of the lead wires of the electronic component that project from the printed board. Therefore, the heat generated in the electronic component is released through the printed board and the lead wires and through the cushioning member and the base to the wall body or the rail. Since the cushioning member is interposed between the printed board and the base, it conducts the heat of the exothermic electronic component mounted on the printed board to the base. Since the heat is conducted from the base to the DIN rail , the casing assembly is cooled efficiently, and no thermal problem arises even when components are densely packaged in the printed board.

To accomplish the fourth aspect, in a preferred embodiment an auxiliary printed board is interposed between the printed board and a flat face of the casing, and an auxiliary frame after being held integrally with the auxiliary printed board is attached to the printed board. Specifically, the base, printed board, auxiliary frame and auxiliary printed board are piled up in that order and covered with the casing. Therefore, since the auxiliary printed board is positioned above the printed board, the packaging area is increased without any appreciable increase in size of the casing assembly because of a two-storied structure. Since the auxiliary frame is attached to the printed board after being made integral with the auxiliary printed board, this facilitates assembling.

To accomplish the fifth aspect, in a further preferred embodiment of the casing assembly for electronic equipment according to the invention a programmer being attached to the casing and connected to the printed board. The programmer is substantially square and has four attaching legs provided at substantially the four vertices thereof and latches provided on the inner side faces of the attaching legs, and the casing has four recesses formed in the upper face thereof correspondingly to the four attaching legs. Therefore, the programmer can be mounted to the casing in the horizontal or vertical position. The programmer is used to set, confirm and read the operating conditions of a CPU or the like mounted in the printed board. Since the four attaching legs are provided at the vertices of a square, the programmer can take each of the two, horizontal and vertical attaching directions or positions by use of the recesses of the casing.

Still further preferred embodiments of the casing assembly are defined in the subclaims.

### BRIEF DESCRIPTION OF THE DRAWINGS

Fig. 1 is an exploded perspective view showing an embodiment of the present invention;
Fig. 2 is a general view showing a casing 10 attached to a DIN rail;
Fig. 3 is a fragmentary view showing a coupling section between the casing 10 and the DIN rail;
Fig. 4 is a view explanatory of the heat release mechanism of the casing 10;
Fig. 5 is a view explanatory of the cooling action due to free convection;
Fig. 6 is a perspective view showing substantially a half of a terminal mount 25;
Fig. 7 is a perspective view showing an auxiliary printed board 50 with an auxiliary frame 60 attached thereto;
Fig. 8 is a sectional view showing the casing 10 and the auxiliary frame 60 combined therewith;
Fig. 9 is a side view explanatory of the stored state of a battery;
Fig. 10 is a perspective view showing a programmer 90 which is going to be mounted in the casing 10;
Fig. 11 is a view showing the programmer 90;
Fig. 12 is a perspective view showing the casing 10 to which the programmer 90 is mounted;
Fig. 13 is a view explanatory of the relationship between the casing 10 and a cover 82;
Fig. 14 is a fragmentary sectional view showing a terminal mount cover 84;
Fig. 15 is a perspective view showing the casing 10 and an extended module 200 before connection; and
Fig. 16 is a fragmentary side view showing the casing 10 and the extended module 200 after connection.

### DESCRIPTION OF THE PREFERRED EMBODIMENT

The present invention will now be described with reference to the drawings.

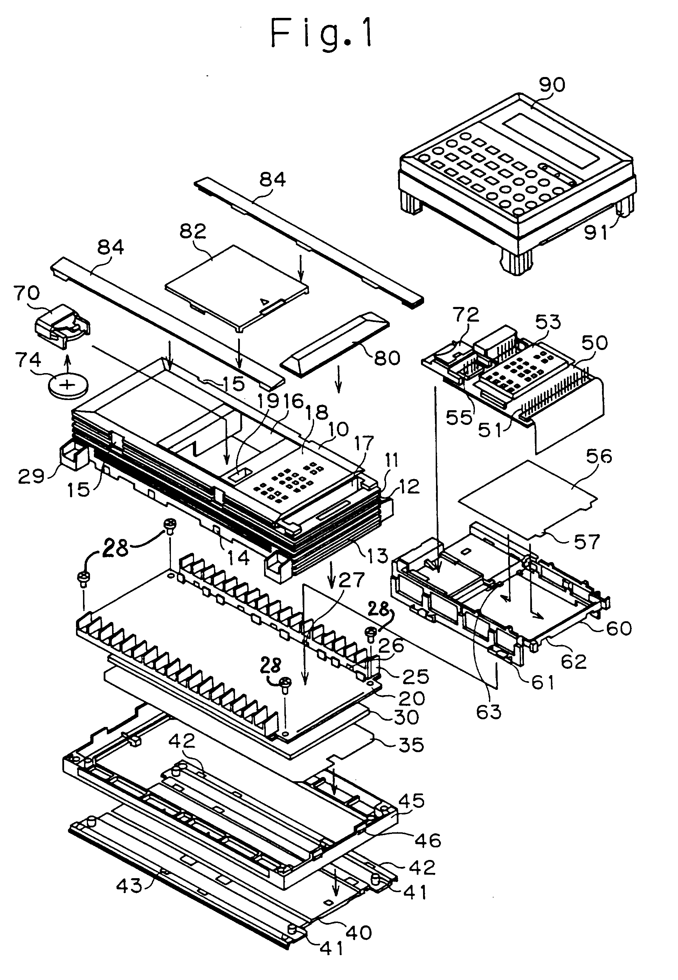

Fig. 1 shows an embodiment of the present invention. In this drawing, a casing 10 has ventilating openings 11 formed in the side faces thereof except a side face to be attached to a wall body, which are defined by ribs 12. Each ventilating opening 11 is made to such a size that foreign matters such as screws cannot enter the casing through it, but free convection is not disturbed by it. The ribs 12 are provided in, for example, lattice form. An engaging portion 13 in the form of a recess or opening is provided along a lower short edge of the casing 10, with which a pawl portion 46 provided on a frame 45 is engaged. An engaging portion 14 in the form of a recess or opening is provided along a lower long edge of the casing 10, with which a pawl portion 27 provided on a terminal mount 25 is engaged. A recess 15 is formed along an upper long edge of the casing 10, which is used to mount a programmer 90. An opening 16 is formed at substantially the center of the upper face of the casing 10, which facilitates changing of a battery 75 and mounting of a ROM pack ( not shown ). A connector hole 17 is formed along an edge of the upper face of the casing 10, in which a main connector 51 for connection with the programmer 90 or checker is disposed. A display cover 18 is used to cover a display light section 53, whose several portions in alignment with light emitting elements are made in the form of translucent windows. A connector hole 19 is formed between the opening 16 and the display cover 18, in which a sub connector 55 is disposed. Cover hold mounts 29 are provided at four corners of the casing 10, to which a terminal mount cover 84 for covering the terminal mount 25 is attached.

A printed board 20 has a self-heating ( exothermic ) electronic component 21 such as power transistors and a passive component such as capacitors mounted thereon. The terminal mount 25 is mounted to a long edge of the printed board 20, whose terminals are connected with signal lines ( not shown ). The terminal mount has convex fixing portions 26 for attaching of an auxiliary printed board 50 and the foregoing pawl portions 27 for coupling with the casing 10. The cover hold mounts 29 are disposed in alignment with the ends of each terminal mount 25.

A cushioning member 30 is attached in contact with the printed board 20, which is made of high heat conductive, electrically insulative, and flexible material. Such materials are rubber, gel, potting or cushioning plastic, and the like, to which preferably silica or the like is added for the purpose of improving heat conductivity. The thickness of the cushioning member 30 is made larger than the height of lead wires and solder attached to the printed board 20 and of components packaged therearound for the purpose of ensuring electric insulation. An insulating member 35 in the form of a plate is interposed between the cushioning member 30 and a base 40, which is made of rigid rubber or the like. The heat conductivity of the insulating member is made identical with that of the cushioning member 30. The purpose of providing the insulating member 35 is to prevent the occurrence of short-circuiting across terminals of the printed board 20 that would result because the cushioning member 30 has flexibility.

The base 40 in contact with the cushioning member 30 is provided to attach the casing 10 to a wall body, which is made of high heat conductive material, such as aluminium or copper, and whose rigidity should be high enough for attachment to the wall body. Studs 41 are provided at four corners of the base 40, which are used to secure the printed board 20 to the base 40 with the cushioning member 30 and the insulating member 35 interposed therebetween by use of screws 28. Two pairs of attaching holes 42 are formed along one long edge of the base 40, which are used to secure two DIN-rail coupling mechanisms ( not shown ). A pair of attaching holes 43 is formed along the other long edge of the base 40, which is used to secure one DIN-rail coupling mechanism ( not shown ). A frame 45 is quadrangular, which when attached to the base 40 leaves a certain clearance between the base 40 and the printed board 20. The two pawl portions 46 provided along each short edge of the frame 45 are resiliently engaged with the engaging portions 13 of the casing 10.

The auxiliary printed board 50 has, for example, signal processing circuits mounted thereon, such components being unfeasible for mounting on the printed board 20 from the view points of noise and cost. From the standpoint of wiring, for example, the auxiliary printed board 50 is made in four-layered form; but, the printed board 20 is made such that its both sides are used. The auxiliary printed board 50 is equipped with a sub connector 55 as well as the main connector 51 for connection with the programmer 90, and provided with the foregoing display light section 53 such as LCD. A shield plate 56 is attached to an auxiliary frame 60 to ensure electric and magnetic insulation between the auxiliary printed board 50 and the printed board 20, which is substantially square and has protrusions 57 formed along one edge thereof.

The auxiliary frame 60 is used to support the auxiliary printed board 50 on the printed board 20, which has notches 62 fittable with the protrusions 57 and a protrusion 63 for receiving the other edge of the shield plate opposite to the protrusions 57. When attaching the auxiliary frame 60 to the printed board 20, a latch 61 is engaged with the fixing portion 26 of the terminal mount 25.

A holder 70 is inserted through the opening 16, which is coupled with a battery storage portion 72 provided on the auxiliary printed board 50 to hold a disc-like battery 74. A connector cover 80 is provided to close the opening 17, a cover 82 is provided to close the opening 16 and the connector hole 19, and the foregoing terminal mount cover 84 is attached to the cover hold mount 29 to cover the terminal mount 25, whereby virtually dust is prevented from entering the casing 10.

The programmer 90 is mounted on the casing 10 and controlled to write data into electronic circuits provided in the printed board 20 and auxiliary printed board 50 or to confirm programs, which can be detachably mounted because latches 91 provided at four corners are detachably engageable with the recesses 15 of the casing 10.

The functions of the foregoing casing assembly will be described.

### Attaching to DIN rail

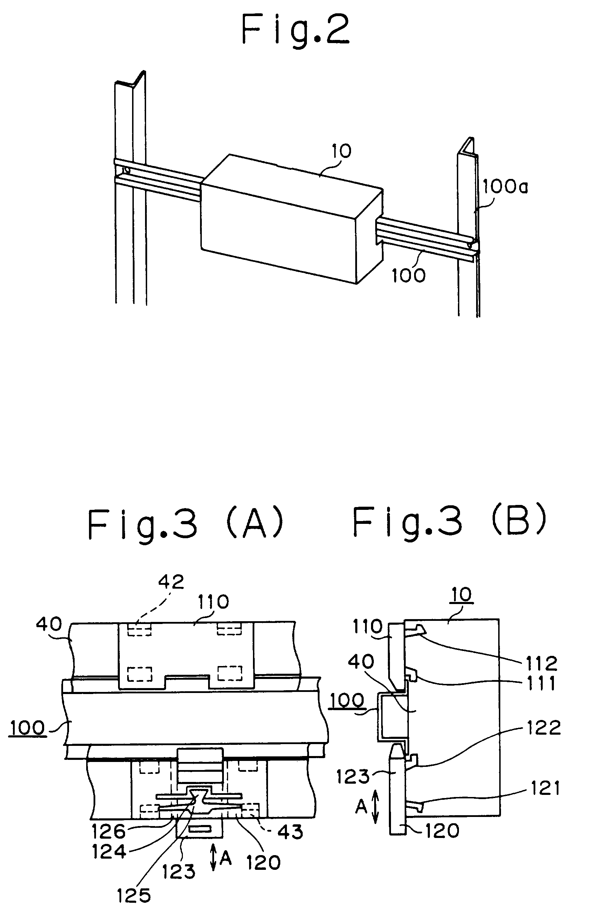

Fig. 2 shows the attached state of the casing 10 to a DIN rail 100. The DIN rail 100 serves also as a beam for a column 100a.

Fig. 3 shows the procedure of attaching the casing 10 to the DIN rail, in which (A) is a bottom view and (B) is a side view. The DIN rail 100 is a standard rail for use in attaching electronic equipment to a structure, which is U-shaped in cross section and has a flange at each edge. A guide latch member 110 is secured to the base 40 by fitting a hook protrusion 111 and a resilient pawl portion 112 in the attaching hole 42 of the base 40. A pressure latch member 120 is secured to the base 40 by fitting a hook protrusion 121 and a resilient pawl portion 122 in the attaching hole 43 of the base 40, whose secured state is attained by pressing a slider 123 against the DIN rail 100. The slider 123 has a convex grip portion 124 at a central portion thereof and is given a restoring force in the direction of the arrow A by a cantilever spring portion 125 such that it is slidable along a groove 126.

If the slider 123 is slid in opposition to the spring portion 125, it comes out of engagement with the DIN rail 100, that is, the casing 10 can be detached. If the slider 123 is positioned midway between its slidable limits, it is not in contact with the DIN rail 100, that is, the casing can be moved along the DIN rail 100. If no force is applied to the slider 123, the slider 123 is pressed against the DIN rail 100 by the spring portion 123, resulting in the fixed state.

Where the casing is to be attached to a usual wall body not to the DIN rail 100, the guide latch member 110 and the pressure latch member 120 are removed from the base 40, and the casing is screwed to the wall body. Since the casing is designed so that the guide latch member 110 and the pressure latch member 120 can be attached to the back side of the base 40, no appreciable difference in external size arises between when the casing 10 is attached to the DIN rail and when it is attached to the wall body, leading to size reduction.

### Heat releasing

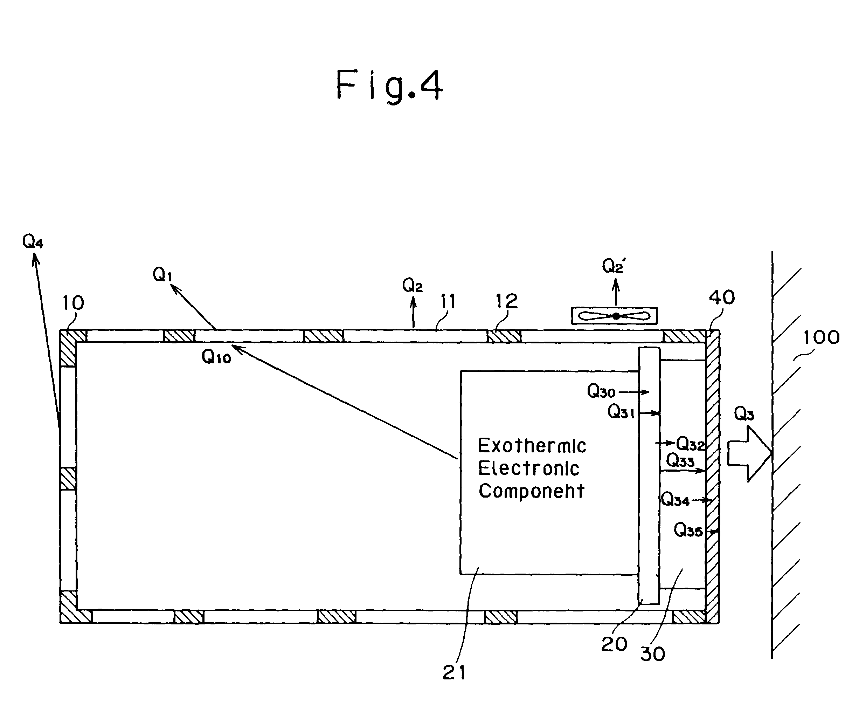

Fig. 4 illustrates the heat release mechanism of the casing 10. The printed board 20 has the exothermic electronic component 21 such as power transistors mounted thereon. The heat generated in the exothermic electronic component 21 is released through radiation, convection and conduction. In the case of radiation, the heat of the exothermic electronic component 21 is transferred to the casing ( Q10 ) and then radiated from the surface of the casing 10 in the form of infrared rays ( Q1 ). Since radiation contributes little, the amount of radiation is generally neglected in the design of heat release. In the case of convection, there are the heat release Q2 resulting from free convection around the ventilating openings 12 and the heat release Q2' resulting from forced convection caused by use of a fan cooler. In the case of conduction, the heat of the exothermic electronic component 21 escapes to the wall body 100 ( inclusive of the DIN rail and column ) to which the casing 10 is attached. Q30 through Q35 and Q3 indicate such heat escape or conduction. Specifically, the heat conduction Q30 is effected by, for example, lead wires from the exothermic electronic component 21 to the printed board 20. The heat conduction Q31 is from one side to the other of the printed board 20. The heat conduction Q32 is from the printed board 20 to the cushioning member 30. The heat conduction Q33 is from one side to the other of the cushioning member 30. The heat conduction Q34 is from the cushioning member 30 to the base 40. The heat conduction Q35 is from one side to the other of the base 40. The heat conduction Q3 is from the base 40 to the wall body 100. It should be noted that the structure or wall body 100 is made to act also as heat radiator.

Heat is transferred through the lead wires of the printed board 20 and/or the exothermic electronic component 21 to the cushioning member 30. Good heat conduction to the base 40 can be attained by making both the cushioning member 30 and the insulating member 35 high in heat conductivity. Since the base 40 is held in contact with the DIN rail as shown in Fig. 2, heat is quickly conducted to the DIN rail 100. Since the cushioning member 30 and the insulating member 35 are interposed between the printed board 20 and the base 40 with adequate pressure, any space of low heat conductivity such as an air layer is virtually not left there.

Therefore, since the structure or DIN rail 100 comparatively larger in size than the casing 10 is utilized as a heat radiating member, the rise of internal temperature can be suppressed even when the heating value of the electronic component on the printed board 20 is large.

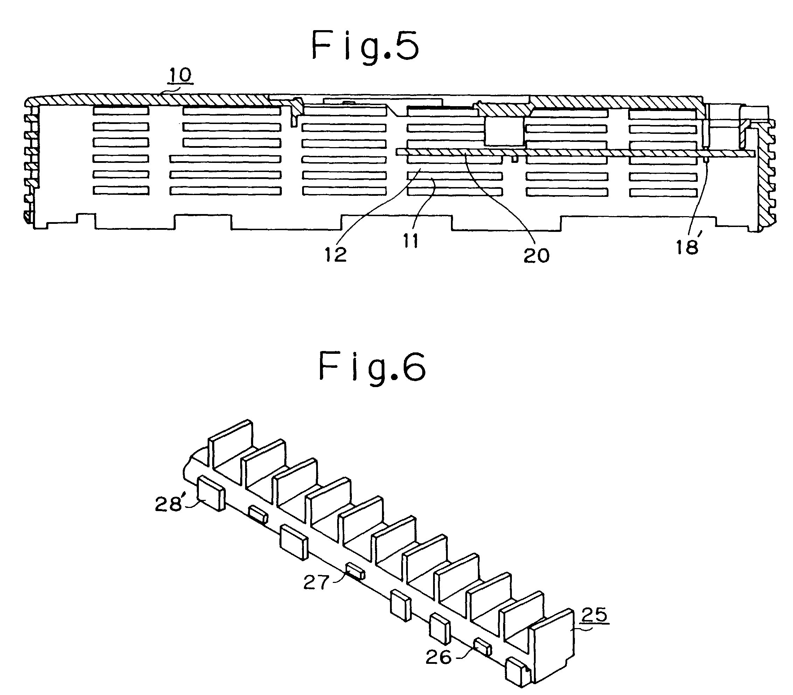

Fig. 5 illustrates the cooling action of free convection. As shown, the printed board 20 is mounted inside the casing such that it does not close the ventilating openings 11 or it is in positional alignment with the ribs 12. A holding portion 18' is provided to determine the attaching position of the printed board 20 inside the casing 10, that is, the height of the holding portion is selected such that the printed board 20 accords in position with the ribs 12.

With the foregoing arrangement, the ventilating openings 11 function well as passages for the free convection caused by the heating of the electronic component mounted on the printed board 20. Therefore, cooling is satisfactorily attained even through free convection. Where forced convection is to be incorporated, fans may be provided as desired.

### Multiple functions of terminal mount

Fig. 6 shows substantially a half of the terminal mount 25. The fixing portion 26 is in the form of a small protrusion provided on the side facing the printed board 20, which is engageable with the latch 61 of the auxiliary frame 60. The pawl portion 27 is substantially identical with the fixing portion 26, which is engageable with the engaging portion 14 of the casing 10. A flex limiting portion 28' is in the form of a protrusion larger than the pawl portion 27, which when coming into contact with the printed board 20 causes the terminal mount 25 to virtually serve as a reinforcing member for the printed board 20. There are provided two terminal mounts 25 in association with one printed board 20. By making all the terminal mounts identical and laterally symmetric, the mounting of the terminal mounts relative to the individual edges of the printed board 20 can be dealt with, this promoting standardization of parts.

### Holding of auxiliary printed board

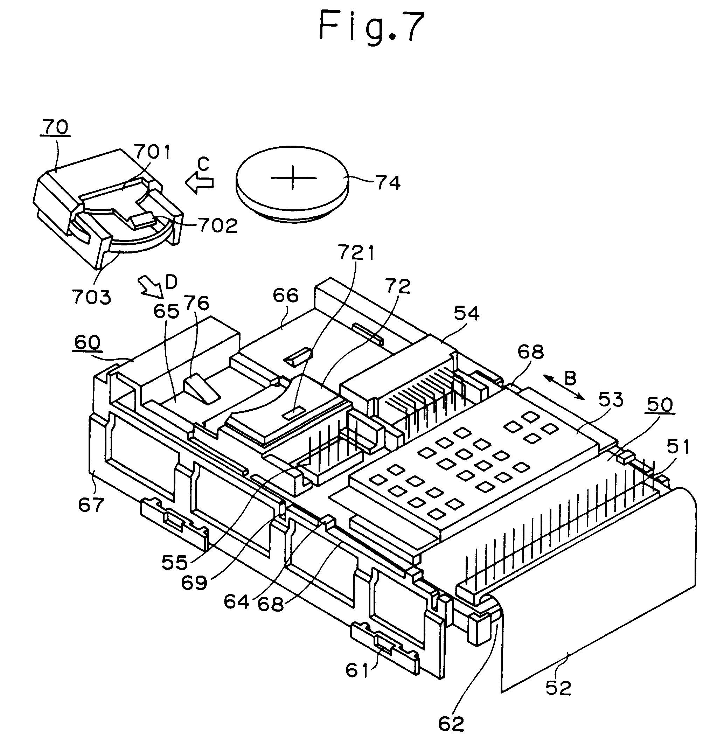

Fig. 7 shows the auxiliary printed board 50 with the auxiliary frame 60 attached thereto. The auxiliary printed board 50 has a cable 52 for connection with the main connector 51. This cable 52 is provided to establish communication between the printed board 20 and the auxiliary printed board 50, that is, various input and output signals are transmitted through the terminal mount 25 between the printed board 20 and the auxiliary printed board 50. A ROM socket 54 is used for connection with the ROM pack. By changing the ROM pack, the substance of signal processing performed by the auxiliary printed board 50 is altered. The sub connector 55 is used, for example, to receive power from the battery 74.

A lock portion 64 is in the form of a pawl-like protrusion provided along an edge of the auxiliary printed board 50, which restricts the vertical movement of the auxiliary printed board 50. A battery chamber 65 is a room for accepting the battery 74 held in the holder 70, which has a slope 76 provided opposite to the battery storage portion 72. This slope 76 facilitates detaching of the holder 70. A ROM chamber 66 has a flat face for receiving the ROM pack. Support legs 67 are provided to ensure a certain clearance between the auxiliary printed board 50 and the printed board 20, which are spaced from one another to define gaps for air flowing. A girder portion 68 is provided to support the auxiliary printed board 50, that is, it supports the auxiliary printed board 50 and the shield plate 56. Notches 69 are formed in the girder portions 68 at four points, which come into engagement with positioning protrusions ( not shown ) of the casing 10 to determine the position of the display light section 53 and display cover 18 in the direction of the arrow B.

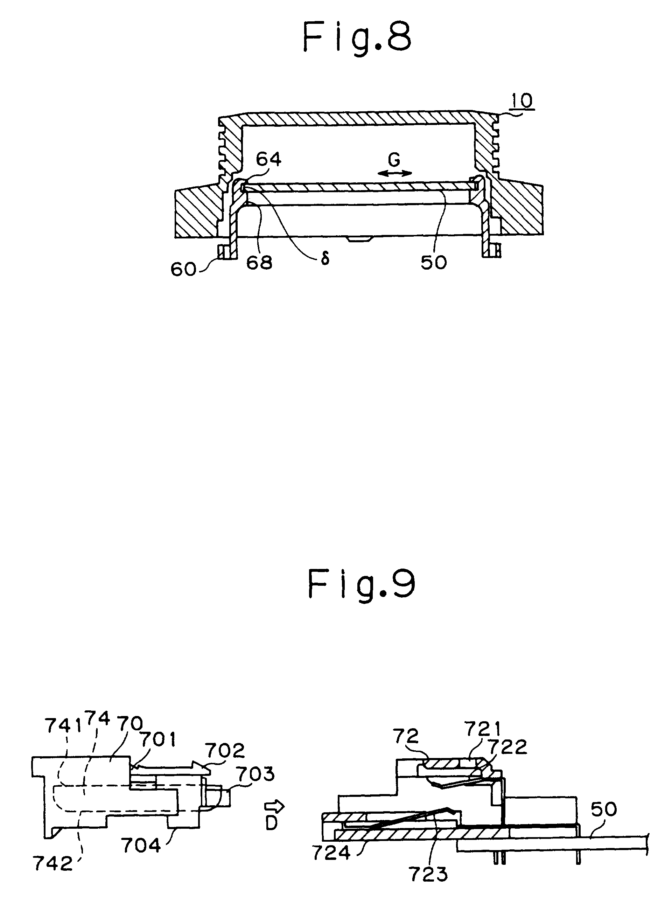

Fig. 8 shows the combined state of the casing 10 with the auxiliary frame 60. Since there is a gap δ between the girder portion 68 and the auxiliary printed board 50, the relative positioning of the display light section 53 and the display cover 18 in the direction of the arrow G is attained. This gap δ absorbs manufacture error and assembly error, leading to an increase in yield.

Fig. 9 shows the stored state of the battery. The holder 70 has a touch portion 701 being controlled when detaching the holder from the battery storage portion 72, a latch 702 acting when attaching the holder to the battery storage portion 72, a stopper face 703 having a circular edge analogous to the shape of the battery 74, and a contact face 704 formed with a notch on the bottom side. The battery storage portion 72 has an opening 721 engageable with the latch 702, an upper contact element 722 coming into pressure contact with an upper electrode 741 of the battery 74 held in the holder 70, a lower contact element 723 coming into pressure contact with a lower electrode 742 of the battery 74, and a guide face 724 coming into contact with the contact face 704.

When the battery 74 is inserted into the holder 70, this results in the state of Fig. 7. When the holder 70 is moved in the direction of the arrow, the latch 702 is engaged with the opening 721, whereby the holder is secured. As a result, the contact elements 722 and 723 are kept in contact with the electrodes 741 and 742, respectively, so that power supply to the auxiliary printed board 50 begins. When detaching the holder, the touch portion 701 is depressed to disengage the latch 702 from the opening 721, so that the holder is allowed to move in the direction opposite to the arrow, whereby the battery can be changed.

### Mounting of programmer

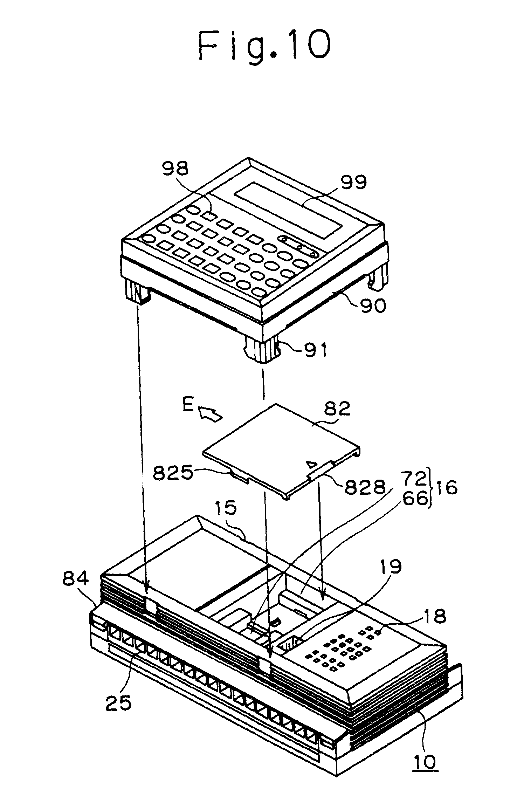

Fig. 10 illustrates the procedure of mounting the programmer 90 on the casing 10. Since the casing 10 is finished, there are accommodated the printed board 20, cushioning member 30, base 40, auxiliary printed board 50, auxiliary frame 60 and the like. The cover 82 has a touch portion 828 formed along one edge thereof which facilitates moving of the cover in the direction of the arrow E. Lock portions 825 are formed along opposing edges of the cover 82 that are orthogonal to the edge having the touch portion 828. Provided on the surface of the programmer 90 are key switches 98 for data entry and a display section 99 for display of keyed data and internal data held in the casing 10, the display section being made of liquid crystal or LED.

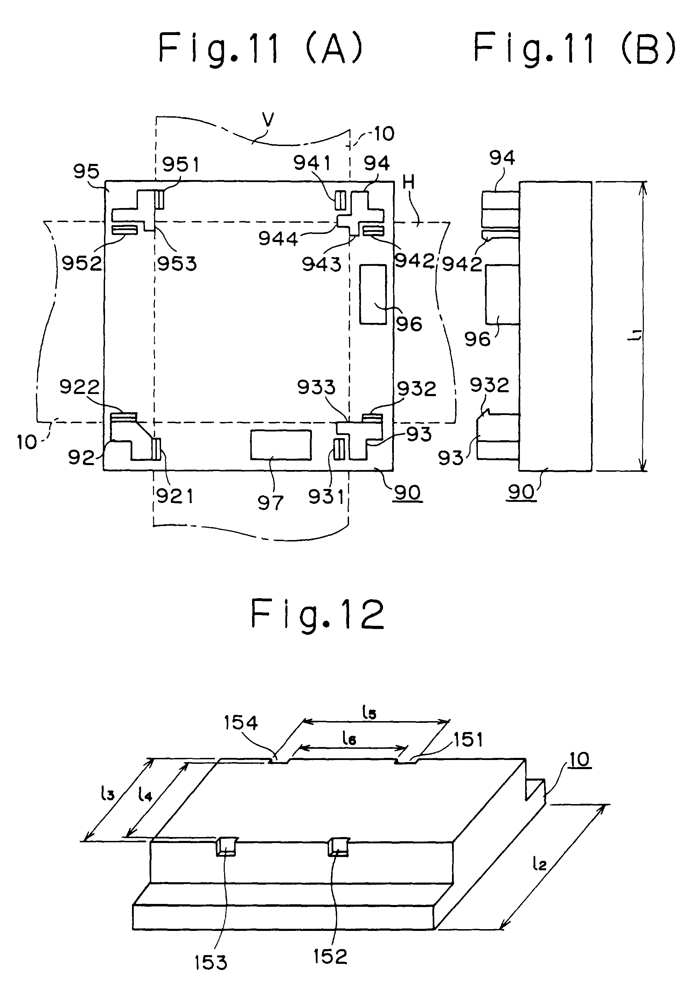

Fig. 11 shows the programmer 90, in which (A) is a bottom view and (B) is a side view. Fig. 12 shows the casing 10 on which the programmer 90 is mounted. The programmer 90 can be mounted on the casing 10 in either the horizontal direction H or the vertical direction V. As shown, an attaching leg 92 has latches 921 and 922 of large rigidity. On the other hand, an attaching leg 93 has a displaceable latch 931 of small rigidity and a latch 932 of large rigidity, the latch 931 facing the latch 921. A guide face 933 aligned with the latch 932 acts as guide when the programmer 90 is attached to the casing 10 in the horizontal direction. An attaching leg 94 has displaceable latches 941 and 942 of small rigidity. The latch 942 faces the latch 932. A positioning protrusion 943 formed on a face parallel to the latch 942 comes into engagement with the recess 15 when the programmer 90 is attached to the casing 10 in the horizontal direction, determining the position of the programmer. Similarly, a positioning protrusion 944 formed on a face parallel to the latch 941 comes into engagement with the recess 15 when the programmer 90 is attached to the casing 10 in the vertical direction, determining the position of the programmer. An attaching leg 95 has a latch 951 of large rigidity which faces the latch 941 and a latch 952 of small rigidity which faces the latch 922. A guide face 953 aligned with the latch 951 acts as guide when the programmer 90 is attached to the casing 10 in the vertical direction. A connector 96 is provided between the attaching legs 93 and 94, which when the programmer 90 is attached in the horizontal direction comes into connection with the sub connector 55 through the connector hole 19. A connector 97 is provided between the attaching legs 92 and 93, which when the programmer is attached in the vertical direction comes into connection with the sub connector 55 through the connector hole 19. The casing 10 has recesses 151 through 154 formed correspondingly to the attaching legs 92 through 95.

The attaching procedure of the programmer will be described. The programmer 90 is square with each side being ℓ1 in length. This length of each side is set substantially equal to the maximum width ℓ2 of the casing 10 ( inclusive of the terminal mounts 25 ) so that the programmer 90 can not project from the casing 10 irrespective of whether it is attached in the horizontal direction or in the vertical direction. The width ℓ3 of the casing 10 where the programmer 90 is attached is set substantially equal to the spacing between the attaching legs 92 and 93 of the programmer 90. The spacing ℓ4 between the recesses 151 and 152 or between the recesses 153 and 154 is set substantially equal to the spacing between the rigid latch 921 and the displaceable latch 931. The outer spacing ℓ5 and inner spacing ℓ6 between the recesses 151 and 154 of the casing 10 are set considering the size of the attaching legs 92 through 95 and the spacing between them. Since the programmer 90 is prevented from displacing by the guide faces 933 and 953 and positioning protrusions 943 and 944 of the attaching legs, no excessive force acts on the connection between the connectors 96 and 97 and the casing 10 even during attaching and detaching, whereby the reliability of the contact elements can be ensured.

### Covering

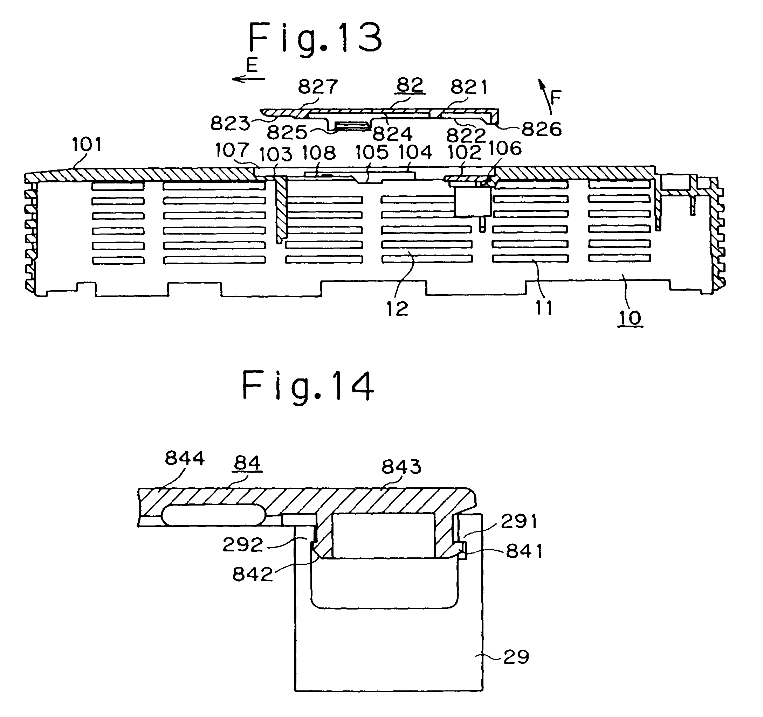

Fig. 13 shows the casing 10 and the cover 82 separated therefrom. As shown, the cover 82 has a front face 821 aligned with the upper side when the cover is attached to the opening 16 of the casing 10, a contact face 822 which is a part of the back side close to one edge, a contact face 823 close to the other edge, and a central back face 824 defined between the two contact faces. A lock portion 825 includes a protrusion formed on the central back face 824, which secures the cover 82 to the casing 10. A protrusion portion 826 is provided at the end of the contact face 822, which facilitates positioning. A stopper portion 827 is a stepped portion provided between the contact face 823 and the lock portion 825.

The casing 10 has a flat face 101 around the opening 16. This flat face 101 is substantially aligned with the front face 821 when the cover 82 is attached. A support face 102 comes into contact with the contact face 822, a support face 103 comes into contact with the contact face 823, and a lateral support face 104 comes into contact with the central back face 824, whereby the cover 82 is supported. A dented face 105 comes into engagement with the lock portion 825 to prevent the cover 82 from coming off the casing 10. A recess 106 comes into engagement with the protrusion portion 826 to prevent the cover 82 from moving in the direction of the arrow E, determining the position of the cover. A check portion 107 is provided at the end of the support face 103, which comes into contact with the stopper portion 827 when the cover 82 moves in the direction of the arrow E, preventing further movement. This distance of movement is larger than the width of the connector hole 19. Since a slide face 108 is provided between the dented face 105 and the support face 103, the bottom face of the lock portion 825 slides on the slide face when it moves in the direction of the arrow E.

The function of the foregoing arrangement will be described. Where the cover 82 is in the close position, the contact faces 822 and 823 and the central back face 824 are in contact with the support faces 102 and 103 and the lateral support face 104, respectively. Since the connector hole 19 is covered with the central back face 824, the programmer 90 cannot be mounted, the battery cannot be changed, and the ROM pack cannot be mounted. Further, the lock portion 825 and the dented face 105 are in engagement, and the protrusion portion 826 and the recess 106 are fitted together.

When the cover 82 is moved in the direction of the arrow E, the lock portion 825 is disengaged from the dented face 105 to run onto the slide face 108, and the protrusion portion 826 is released from the recess 106. Then, the check portion 107 comes into contact with the stopper portion 827, preventing further movement. Consequently, the connector hole 19 is exposed so that the programmer 90 can be mounted on the casing 10. Here, the cover 82 serves as a cover for the battery 74 and a cover for the ROM pack. When the cover 82 is moved in the direction of the arrow F, the lock portion 825 separates from the slide face 108, exposing the inside through the opening 16.

Fig. 14 shows the terminal mount cover 84. To secure the terminal mount cover 84 to the cover hold mount 29, the terminal mount cover 84 has at its end an engaging portion 843 including a fixed protrusion portion 841 and a movable protrusion portion 842 whose length of projection is smaller than that of the former. A plate portion 844 of the terminal mount cover 84 for covering the terminal mount 25 is made thin and low in rigidity. The cover hold mount 29 has a recess 291 adapted for engagement with the fixed protrusion portion 841 and a small protrusion 292 adapted for engagement with the movable protrusion portion 842.

When assembling, the engaging portion 843 is placed on the cover hold mount 29, the fixed protrusion portion 841 is inserted into the recess 291, and force is applied from above such that the movable protrusion portion 842 comes into engagement with the small protrusion 292, whereby the two parts are latched together. When disassembling, the thin plate portion 844 is deformed in the thicknesswise direction. Consequently, some excessive force acts on the movable protrusion portion 842 such that the movable protrusion portion is disengaged from the small protrusion 292. As a result, force is concentrated on the fixed protrusion portion 841, and the thin plate portion 844 inclusive of the engaging portion 843 undergoes bending deformation to come out of engagement with the recess 291, whereby the terminal mount cover 84 can be separated from the cover hold mount 29.

### Connecting of extended module

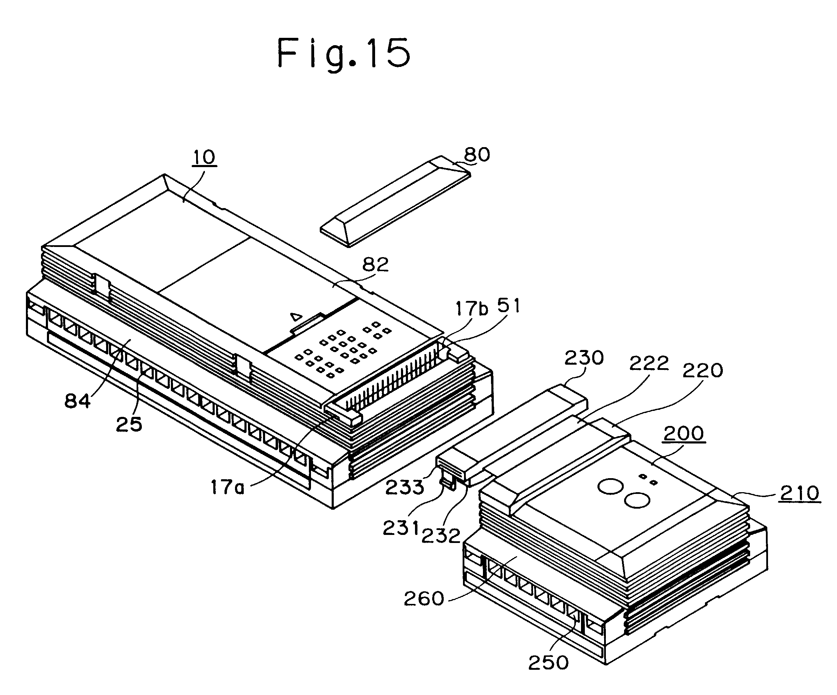

Fig. 15 shows the procedure of connecting the casing ( basic module ) 10 with an extended module 200. The extended module 200 is used where the functions of the auxiliary printed board 50 in the casing 10 are not sufficient for given purposes, that is, the extended module is employed to incorporate additional functions. Since it is desirable that the cable be made as short as possible, the extended module is attached in adjacent relation in principle. The extended module 200 has, along the opposing edges of its upper face, a connector cover 210 for connection with a succeeding module and a fixed-side cable cover 220 for connection with a preceding module. The connector cover 210 is made substantially identical with the cover 80 for covering the connector hole 17. A flat cable 222 made up of signal lead wires is used to electrically connect this extended module 200 with the basic module or the preceding extended module, which is equipped with the fixed-side cable cover 220 at one end and a movable-side cable cover 230 at the other end. A terminal mount 250 is provided to connect the signal lead wires to the extended module 200, which is shorter than the terminal mount 25 for the basic module. A terminal mount cover 260 is provided to cover the terminal mount 250.

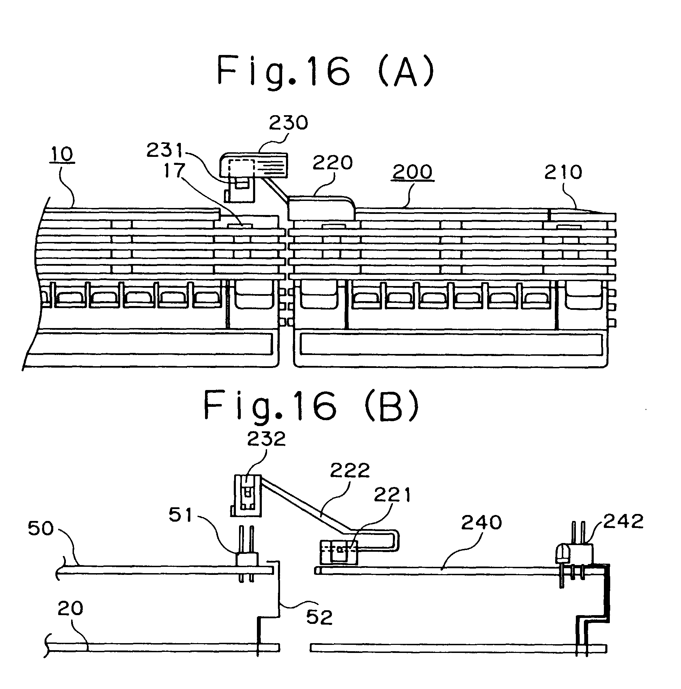

Fig. 16 shows the connected state of the casing 10 with the extended module 200, in which (A) is a front view and (B) is a schematic view of the electrical connection between the printed boards. The movable-side cable cover 230 with a latch 231 is disposed in the connector hole 17 in place of the connector cover 80; thus, the main connector 51 will be connected with a joint connector 232. The fixed-side cable cover 220 and the movable-side cable cover 230 are made laterally symmetric, whose individual height is set slightly higher than the top of the casing 10 or extended module 200, this resulting in no appreciable unevenness on the surface of the modules after connection of the flat cable 222. The fixed-side cable cover 220 covers an extended connector 221 connected with a printed board 240, and the movable-side cable cover 230 covers the joint connector 232 connected with the main connector 51. The two connectors 221 and 232 are connected together by the flat cable 222. An extended connector 242 is mounted on the printed board 240 and covered with the connector cover 210.

As shown, the movable-side cable cover 230 is provided in the extended module 200 for connection with the casing 10. That is, the casing 10 exclusive of the extended module 200 includes substantially no parts uncalled therefor, this incuring no additional costs. Since the flat cable 222 is covered with the cable covers 220 and 230, it is well protected without any portion exposed from the casing surface. Where another ( succeeding ) extended module 200a is to be connected in addition to the ( preceding ) extended module 200, the connector cover 210 of the preceding extended module 200 is removed, and the movable-side cable cover 230 of the succeeding extended module 200a is attached, whereby the two modules can be electrically connected together through the extended connector 242 and the joint connector 232.

### Assembling

Referring again to Fig. 1, the procedure of assembling a casing assembly for electronic equipment will be described. First, the printed board 20 with the electronic component, terminal mounts 25 and the like attached thereto is attached by use of the screws 28 to the base 40 together with the cushioning member 30, insulating member 35 and frame 45. Then, the auxiliary printed board 50 is mounted to the auxiliary frame 60 together with the shield plate 56, the resulting combination is attached to the printed board 20, and the cable 52 is connected as desired. The casing 10 is attached to cover the printed board 20 with the auxiliary printed board 50 mounted thereon, and all the covers are attached.

Where the casing is to be attached to the DIN rail, the guide latch member 110 and the pressure latch member 120 are attached to the base 40. As illustrated, the programmer 90 can be mounted on the casing 10, and the battery 74 and the ROM pack can be changed after opening the cover 82.

The foregoing piled-up structure facilitates assembling.

As described above, the present invention provides the following effects:
1) Since the guide latch member 110 and the pressure latch member 120 are made detachable with respect to the base 40 to deal with the situation where the casing assembly for electronic equipment is to be attached to the DIN rail or the wall body, the casing assembly for electronic equipment can be small in size because these members are removed when attaching to the wall body.
2) Since the heat generated in the printed board 20 is transferred to the DIN rail or the wall body to which the casing assembly for electronic equipment is attached, the cooling power is enhanced. Since the printed boards 20 and 50 are positioned in alignment with the ribs 12 so as not to close the ventilating openings 11, the cooling power based on free convection is large.
3) Since the terminal mount 25 serves also as the structural member of the printed board 20, the number of parts is decreased, lightening the assembling work as compared to the prior art.
4) Since the auxiliary printed board 50 is attached to the printed board 20 via the auxiliary frame 60, the assembling work is easy. Since the auxiliary frame 60 is attached to the terminal mounts 25, the arrangement of parts on the printed board 20 is not limited.
5) Since the attaching direction of the programmer 90 relative to the casing 10 can be selected as desired, the degree of freedom relating to the attaching direction is enhanced and the work effectiveness is improved. Since the positional relationship between the programmer and the casing is defined by the attaching legs, no excessive force acts on the connector, increasing the reliability of it.
6) Since the cover 82 serves also as the covers for the connector hole 19, battery 74, etc., several parts can be used in common. Since the connector of frequent use can be put in use only by sliding the cover 82, the work effectiveness is good.
7) Since the extended module 200 is connected to the casing 10 by use of the movable-side cable cover 230, the system is easy to extend. Since another extended module can be connected to the first extended module, several extended modules can be connected to one basic module.

## Claims

1. A casing assembly for electronic equipment comprising a printed board (20) on which an exothermic electronic component (21) is mounted,
a casing (10) for covering the printed board (20), and
a base (40) for attaching the casing (10) to a rail (100), wherein
the base (40) is made of high heat conductive material and has a planar structure which results in a large contact area between it and the rail (100), and
a high heat conductive plate-like cushioning member (30) made of electrically insulative material is interposed between the printed board (20) and the base (40) in contact with them, whereby the heat generated in the electronic component is released through the printed board (20) and lead wires and through the cushioning member (30) and the base (40) to the rail (100), wherein
said rail (100) has a substantially U-shaped cross section and two flanges,
a guide latch member (110) is detachably mounted to the base (40) which comes into engagement with one flange of the rail (100), and
a pressure latch member (120) is detachably mounted to the base (40) which comes into engagement with the other flange of the rail (100) and has a slider (123) coming into resilient and pressure contact with the rail (100).

2. A casing assembly for electronic equipment according to claim 1, wherein said heat conductive plate-like cushioning member (30) is made of a flexible material, whose thickness is larger than the projection length of the lead wires which project a little distance from the printed board (20) toward the base (40).

3. A casing assembly for electronic equipment according to claim 1 or 2, wherein
the guide latch member (110) has a pawl portion (112) and a hook protrusion (111) which come into engagement with an attaching hole (42) formed in the base (40), and
the pressure latch member (120) has a pawl portion (122) and a hook protrusion (121) which come into engagement with an attaching hole (43) formed in the base (40),
whereby if the casing is to be attached to the rail (100), the guide latch member (110) and the pressure latch member (120) are mounted to the base (40).

4. A casing assembly for electronic equipment according to claim 1 or 2, wherein
the slider (123) of the pressure latch member (120) is slidable within at least a range corresponding to the width of the flange of the rail (100), and
the pressure latch member (120) further has a knob portion (124) provided on the slider (123) and a spring portion (125) for applying an urging force to the slider (123) such that the slider (123) approaches the rail (100),
whereby if the slider (123) is to be separated from the rail (100), the knob portion (124) is controlled to move the slider (123) in opposition to the urging force of the spring portion (125).

5. A casing assembly for electronic equipment according to one of the preceding claims, wherein
an auxiliary printed board (50) is interposed between the printed board (20) and a flat face of the casing (10),
an auxiliary frame (60) having a latch (61) is provided and is attached to the printed board (20) after being held integrally with the auxiliary printed board (50),
two terminal mounts (25) having a fixing portion (26) provided on the side facing the printed board (20) are attached to either edge of the printed board (20),
whereby the base (40), printed board (20), auxiliary frame (60) and auxiliary printed board (50) are piled up in that order and covered with the casing (10), and the auxiliary frame (60) is fixed to the terminal mounts (25) by engaging the latch (61) to the fixing portion (26).

6. A casing assembly for electronic equipment according to claim 5, wherein
the casing (10) has two cover hold mounts (29), which are provided at the longitudinal ends of each terminal mount (25) attached to the printed board (20), the width of the casing (10) is set substantially equal to the inner spacing between the terminal mounts (25) attached to the printed board (20), and
a terminal mount cover (84) is attached at both ends to each cover hold mount (29) to cover each terminal mount (25).

7. A casing assembly for electronic equipment according to claim 6, wherein
the terminal mount cover (84) has two engaging portions (843) provided at the ends thereof which face the cover hold mount (29), a fixed protrusion (841) provided on the outer face of the engaging portion (843), a movable protrusion (842) provided on the inner face of the engaging portion (843) whose projection length is smaller than that of the fixed protrusion (841), and a thin plate portion (844) of small rigidity for covering the terminal mount (25), and
the cover hold mount (29) has a recess (291) engageable with the fixed protrusion (841) and a short protrusion (292) engageable with the movable protrusion (842),
whereby if the terminal mount cover (84) is to be attached to the cover hold mount (29), the thin plate portion (844) is flexed, the fixed protrusion (841) is inserted into the recess (291), the engaging portion (843) is depressed toward the cover hold mount (29), and the movable protrusion (844) is brought into engagement with the short protrusion (292).

8. A casing assembly for electronic equipment according to one of the preceding claims, wherein
a programmer (90) being attached to the casing (10) is provided,
the programmer (90) is substantially square and has four attaching legs (92-95) provided at substantially the four vertices thereof, and latches provided on the inner side faces of the attaching legs (92-95),
at least two connectors (96, 97) are provided on its face where the attaching legs (92-95) are provided, and
four recesses (15) are formed in the upper face of the casing (10) in correspondence with the four attaching legs (92-95),
whereby the programmer (90) is attached to the casing (10) in the horizontal or vertical position by bringing the attaching legs (92-95) into engagement with the recesses (15) and one of the connectors (96, 97) is connected through a connector hole (19) to a connector (55) of the printed board (50).

9. A casing assembly for electronic equipment according to claim 8, wherein
the four attaching legs (92-95) are substantially rectangular in cross section, the inner side faces of each attaching leg are in confronting relation to those of the adjacent legs,
the first attaching leg (92) has on its inner side faces two latches (921, 922) of large rigidity,
the second attaching leg (93) has on its inner side faces a displaceable latch of small rigidity (931) and a latch of large rigidity (932), the displaceable latch of small rigidity (931) facing the one latch (921) of the first attaching leg (92),
the third attaching leg (94) has on its inner side faces two displaceable latches of small rigidity (941, 942), the one displaceable latch (942) facing the latch of large rigidity (932) of the second attaching leg (93),
the fourth attaching leg (95) has on its inner side faces a displaceable latch of small rigidity (952) and a latch of large rigidity (951), the displaceable latch of small rigidity (952) facing the other latch (922) of the first attaching leg (92) and the latch of large rigidity (951) facing the displaceable latch of small rigidity (941) of the third attaching leg (94).

10. A casing assembly for electronic equipment according to claim 9, wherein
the second attaching leg (93) has a guide face (933) in alignment with its latch of large rigidity (932),
the third attaching leg (94) has a first positioning protrusion (943) formed on a face parallel to its one latch (942) and a second positioning protrusion (944) formed on a face parallel to its other latch (941), and
the fourth attaching leg (95) has a guide face (953) in alignment with its latch of large rigidity (951),
whereby if the programmer (90) is to be attached to the casing (10) in the horizontal position, the guide face (933) of the second attaching leg (93) acts as guide and the first positioning protrusion (943) comes into engagement with the recess (15), and
if the programmer (90) is to be attached to the casing in the vertical position, the guide face (953) of the fourth attaching leg (95) acts as guide and the second positioning protrusion (944) comes into engagement with the recess (15).

## Patentansprüche

1. Gehäuseanordnung für eine elektrische Anlage, umfassend eine (gedruckte) Leiterplatte (20), auf der ein exothermes elektronisches Bauteil (21) montiert ist,
ein Gehäuse (10) zum Abdecken der Leiterplatte (20) und
eine Basis (40) zum Anbringen des Gehäuses (10) an einer Schiene (100), wobei
die Basis (40) aus einem hoch oder gut wärmeleitfähigen Werkstoff geformt ist und eine plane Struktur aufweist, die eine große Kontakt(ober)fläche zwischen ihr und der Schiene (100) ergibt, und
ein hoch bzw. gut wärmeleitfähiges, plattenförmiges Pufferelement (30) aus einem elektrisch isolierenden Werkstoff zwischen die Leiterplatte (20) und die Basis (40) in Kontakt oder Berührung mit diesen eingefügt ist, so daß die im elektronischen Bauteil erzeugte Wärme über die Leiterplatte (20) und Zuleitungen sowie über das Pufferelement (30) und die Basis (40) zur Schiene (100) abgeführt wird, wobei
die Schiene (100) einen im wesentlichen U-förmigen Querschnitt und zwei Flansche aufweist,
an der Basis (40) ein Führungsklinkenelement (110) abnehmbar montiert ist, das mit einem Flansch der Schiene (100) in Eingriff gelangt, und
ein Druckklinkenelement (120) abnehmbar an der Basis (40) montiert ist, welches in Eingriff mit dem anderen Flansch (100) gelangt und einen in elastische Druckberührung mit der Schiene (100) gelangenden Schieber (123) aufweist.

2. Gehäuseanordnung für eine elektronische Anlage nach Anspruch 1, wobei das wärmeleitfähige, plattenförmige Pufferelement (30) aus einem flexiblen Werkstoff besteht, dessen Dicke größer ist als die Vorstandslänge der Zuleitungen, die über eine kleine Strecke von der Leiterplatte (20) in Richtung auf die Basis (40) vor- oder abstehen.

3. Gehäuseanordnung für eine elektronische Anlage nach Anspruch 1 oder 2, wobei
das Führungsklinkenelement (110) ein Klauenteil (112) und einen Hakenvorsprung (111) aufweist, die mit einer in der Basis (40) geformten Einbau- oder Anbauöffnung (42) in Eingriff gelangen, und
das Druckklinkenelement (120) ein Klauenteil (122) und einen Hakenvorsprung (121) aufweist, die mit einer in der Basis (40) geformten Einbau- oder Anbauöffnung (43) in Eingriff gelangen,
wobei dann, wenn das Gehäuse an der Schiene (100) angebracht werden soll, das Führungsklinkenelement (110) und das Druckklinkenelement (120) an der Basis (40) montiert sind oder werden.

4. Gehäuseanordnung für eine elektronische Anlage nach Anspruch 1 oder 2, wobei
der Schieber (123) des Druckklinkenelements (120) zumindest innerhalb eines Bereichs entsprechend der Breite des Flansches der Schiene (100) verschiebbar ist und
das Druckklinkenelement (120) ferner ein am Schieber (123) vorgesehenes Knopfteil (124) und ein Federteil (125) zum Ausüben einer Vorbelastungskraft auf den Schieber (123), so daß sich der Schieber (123) der Schiene (100) (an)nähert, aufweist,
wobei dann, wenn der Schieber (123) von der Schiene (100) getrennt werden soll, das Knopfteil (124) betätigt (controlled) wird, um den Schieber (123) entgegen der Vorbelastungskraft des Federteils (125) zu verschieben.

5. Gehäuseanordnung für eine elektronische Anlage nach einem der vorangehenden Ansprüche, wobei
eine Hilfsleiterplatte (50) zwischen die Leiterplatte (20) und eine flache Fläche bzw. Planfläche des Gehäuses (10) eingefügt ist,
ein Hilfsrahmen (60) mit einer Sperre oder Klinke (61) vorgesehen und an der Leiterplatte (20) angebracht ist, nachdem diese einheitlich mit der Hilfsleiterplatte (50) zusammengehalten worden ist,
zwei Anschlußhalterungen (25) mit einem an der der Leiterplatte (20) zugewandten Seite vorgesehenen Fixierteil (26) an jeder Kante der Leiterplatte (20) angebracht sind,
wobei die Basis (40), die Leiterplatte (20), der Hilfsrahmen (60) und die Hilfsleiterplatte (50) in dieser Reihenfolge übereinander gestapelt und mit dem Gehäuse (10) abgedeckt sind und der Hilfsrahmen (60) durch Einrasten der Klinke (61) am Fixierteil (26) an den Anschlußhalterungen (25) fixiert bzw. befestigt ist.

6. Gehäuseanordnung für eine elektronische Anlage nach Anspruch 5, wobei
das Gehäuse (10) zwei Deckel(sicherungs)halterungen (29) aufweist, die an den Längs-Enden jeder an der Leiterplatte (20) angebrachten Anschlußhalterung (25) vorgesehen sind, wobei die Breite des Gehäuses (10) praktisch gleich dem inneren Abstand zwischen den an der Leiterplatte (20) angebrachten Anschlußhalterungen (25) eingestellt ist, und
an beiden Enden jeder Deckelhalterung (29) ein Anschlußhalterungsdeckel (84) zum Abdecken jeder Anschlußhalterung (25) angebracht ist.

7. Gehäuseanordnung für eine elektronische Anlage nach Anspruch 6, wobei
der Anschlußhalterungsdeckel (84) zwei an seinen Enden vorgesehene, der Deckelhalterung (29) zugewandte Einrastteile (843), einen an der Außenfläche des Einrastteils (843) vorgesehenen festen Vorsprung (841), einen an der Innenfläche des Einrastteils (843) vorgesehenen bewegbaren Vorsprung (842), dessen Vorstandslänge kleiner ist als die des festen Vorsprungs (841), und ein dünnes Plattenteil (844) einer geringen Steifheit zum Abdecken der Anschlußhalterung (25) aufweist und
die Deckelhalterung (29) eine Ausnehmung (291), in welche der feste Vorsprung (841) einrastbar ist, und einen kurzen, mit dem bewegbaren Vorsprung (842) in Eingriff bringbaren Vorsprung (292) aufweist,
wobei dann, wenn der Anchlußhalterungsdeckel (84) an der Deckelhalterung (29) angebracht werden soll, das dünne Plattenteil (844) durchgebogen, der feste Vorsprung (841) in die Ausnehmung (291) eingesetzt, das Einrastteil (843) in Richtung auf die Deckelhalterung (29) (ein)gedrückt und der bewegbare Vorsprung (844) mit dem kurzen Vorsprung (292) in Eingriff gebracht werden.

8. Gehäuseanordnung für eine elektronische Anlage nach einem der vorangehenden Ansprüche, wobei
ein am Gehäuse (10) angebrachtes Programmierungsgerät (90) vorgesehen ist,
das Programmierungsgerät (90) im wesentlichen quadratisch ist und vier praktisch an seinen vier Spitzen bzw. Ecken vorgesehene Anbaufüße (92 - 95) sowie an den Innenseitenflächen der Anbaufüße (92 - 95) vorgesehene Verriegelungen bzw. Klinken aufweist,
an seiner Fläche, an welcher die Anbaufüße (92 - 95) vorgesehen sind, mindestens zwei Verbinder (96, 97) vorgesehen sind und
in der Oberseite des Gehäuses (10) vier Ausnehmungen (15) in Entsprechung zu den vier Anbaufüßen (92 - 95) geformt sind,
wobei das Programmierungsgerät (90) am Gehäuse (10) in der Horizontal- oder der Vertikallage anbringbar ist, indem die Anbaufüße (92 - 95) mit den Ausnehmungen (15) in Eingriff gebracht werden und einer der Verbinder (96, 97) über eine Verbinderöffnung (19) an einen Verbinder (55) der Leiterplatte (20) angeschlossen wird.

9. Gehäuseanordnung für eine elektronische Anlage nach Anspruch 8, wobei
die vier Anbaufüße (92 - 95) einen im wesentlichen rechteckigen Querschnitt besitzen und die Innenseitenflächen jedes Anbaufußes in gegenüberstehender Beziehung zu denen der angrenzenden Füße angeordnet sind,
der erste Anbaufuß (92) an seinen Innenseitenflächen zwei Klinken (921, 922) großer Steifheit aufweist,
der zweite Anbaufuß (93) an seinen Innenseitenflächen eine verschiebbare Klinke (931) kleiner Steifheit und eine Klinke (932) großer Steifheit aufweist, wobei die verschiebbare Klinke (931) kleiner Steifheit der einen Klinke (921) des ersten Anschlußfußes (92) zugewandt ist,
der dritte Anbaufuß (94) an seinen Innenseitenflächen zwei verschiebbare Klinken (941, 942) kleiner Steifheit aufweist, von denen die eine verschiebbare Klinke (942) der Klinke (932) großer Steifheit des zweiten Anbaufußes (93) zugewandt ist, (und)
der vierte Anbaufuß (95) an seinen Innenseitenflächen eine verschiebbare Klinke (952) kleiner Steifheit und eine Klinke (951) großer Steifheit aufweist, wobei die verschiebbare Klinke (952) kleiner Steifheit der anderen Klinke (922) des ersten Anbaufußes und die Klinke (951) großer Steifheit der verschiebbaren Klinke (941) kleiner Steifheit des dritten Anbaufußes (94) zugewandt sind.

10. Gehäuseanordnung für eine elektronische Anlage nach Anspruch 9, wobei
der zweite Anbaufuß (93) eine Führungsfläche (933) aufweist, die auf seine Klinke (932) großer Steifheit ausgerichtet ist,
der dritte Anbaufuß (94) einen an einer parallel zu seiner einen Klinke (942) liegenden Fläche geformten ersten Positioniervorsprung (943) und einen an einer parallel zu seiner anderen Klinke (941) liegenden Fläche geformten zweiten Positioniervorsprung (944) aufweist und
der vierte Anbaufuß (95) eine Führungsfläche (953) aufweist, die auf seine Klinke (951) großer Steifheit ausgerichtet ist,
wobei dann, wenn das Programmierungsgerät (90) in der Horizontallage am Gehäuse (10) angebracht werden soll, die Führungsfläche (933) des zweiten Anbaufußes (93) als Führung wirkt und der erste Positioniervorsprung (943) mit der Ausnehmung (15) in Eingriff gelangt, und
dann, wenn das Programmierungsgerät (90) in der Vertikallage am Gehäuse angebracht werden soll, die Führungsfläche (953) des vierten Anbaufußes (95) als Führung wirkt und der zweite Positioniervorsprung (944) mit der Ausnehmung (15) in Eingriff gelangt.

## Revendications

1. Une structure de boîtier pour équipement électronique, comportant une carte à circuits imprimés (20) sur laquelle est monté un composant électronique exothermique (21),
un boîtier (10) pour couvrir la carte à circuits imprimés (20), et
une base (40) pour assujettir le boîtier (10) à un rail (100), dans laquelle
la base (40) est faite d'une matière hautement conductrice de la chaleur et présente une structure plane qui provoque une aire de contact importante entre elle-même et le rail (100), et
un élément d'amortissement (30) analogue à une plaque et hautement conducteur de la chaleur, fait d'une matière électriquement isolante, est interposé entre la carte à circuits imprimés (20) et la base (40) en contact avec eux, de sorte que la chaleur engendrée dans le composant électronique est libérée à travers la carte à circuits imprimés (20) et les fils conducteurs et à travers l'élément d'amortissement (30) et la base (40) jusqu'au rail (100), dans laquelle
ledit rail (100) présente une section droite sensiblement en forme de U et deux branches,
un élément verrou de guidage (110) est monté de manière séparable sur la base (40) qui vient en coopération avec une branche du rail (100), et
un élément verrou de pression (120) est monté de manière séparable sur la base (40) qui vient en coopération avec l'autre branche du rail (100) et comporte un coulisseau (123) venant en contact élastique et de pression avec le rail (100).

2. Une structure de boîtier pour équipement électronique selon la revendication 1, dans laquelle ledit élément d'amortissement (30) analogue à une plaque et conducteur de la chaleur est fait d'une matière souple dont l'épaisseur est supérieure à la longueur en saillie des fils conducteurs qui font saillie d'une faible distance par rapport à la carte à circuits imprimés (20) vers la base (40).

3. Une structure de boîtier pour équipement électronique selon la revendication 1 ou 2, dans laquelle
l'élément verrou de guidage (110) comporte une partie en cliquet (112) et une saillie en crochet (111) qui viennent en coopération avec un orifice de fixation (42) formé dans la base (40), et
l'élément verrou de pression (120) comporte une partie de cliquet (122) et une saillie en crochet (121) qui viennent en coopération avec un orifice de fixation (43) formé dans la base (40),
de sorte que, si le boîtier doit être assujetti au rail (100), l'élément verrou de guidage (110) et l'élément verrou de pression (120) sont montés sur la base (40).

4. Une structure de boîtier pour équipement électronique selon la revendication 1 ou 2, dans laquelle
le coulisseau (123) de l'élément verrou de pression (120) peut coulisser suivant au moins une plage correspondant à la largeur de la branche du rail (100), et
l'élément verrou de pression (120) comporte au surplus une partie en bouton (124) prévue sur le coulisseau (123) et une partie en ressort (125) pour appliquer une force de sollicitation sur le coulisseau (123) de telle manière que le coulisseau (123) se rapproche du rail (100),
de sorte que, si le coulisseau (123) doit être séparé du rail (100), la partie en bouton (124) est commandée pour déplacer le coulisseau (123) à l'encontre de la force de sollicitation de la partie en ressort (125).

5. Une structure de boîtier pour équipement électronique selon l'une des revendications précédentes, dans laquelle
une carte auxiliaire à circuits imprimés (50) est interposée entre la carte à circuits imprimés (20) et une face plane du boîtier (10),
un bâti auxiliaire (60) comportant un verrou (61) est prévu et est assujetti à la carte à circuits imprimés (20) après avoir été maintenu solidairement avec la carte auxiliaire à circuits imprimés (50),
deux montures de bornes (25) comportant une partie de fixation (26) prévue du côté en regard de la carte à circuits imprimés (20) sont fixées sur chaque bord de la carte à circuits imprimés (20),
de sorte que la base (40), la carte à circuits imprimés (20), le bâti auxiliaire (60) et la carte auxiliaire à circuits imprimés (50) sont empilés dans cet ordre et recouverts par le boîtier (10), et le bâti auxiliaire (60) est fixé aux montures de bornes (25) en faisant coopérer le verrou (61) avec la partie de fixation (26).

6. Une structure de boîtier pour équipement électronique selon la revendication 5, dans laquelle
le boîtier (10) comporte deux montures (29) de tenue de couvercle, qui sont prévues aux extrémités longitudinales de chaque monture de bornes (25) fixée à la carte à circuits imprimés (20), la largeur du boîtier (10) est établie pour être sensiblement égale à l'espace intérieur entre les montures de bornes (25) fixées à la carte à circuits imprimés (20), et
un couvercle (84) de monture de bornes est fixé aux deux extrémités de chaque monture (29) de tenue de couvercle pour couvrir chaque monture de bornes (25).

7. Une structure de boîtier pour équipement électronique selon la revendication 6, dans laquelle
le couvercle (84) de monture de bornes comporte deux parties de coopération (843) prévues à ses extrémités, qui sont en regard de la monture (29) de tenue de couvercle, une saillie fixe (841) prévue sur la face extérieure de la partie de coopération (843), une saillie mobile (842) prévue sur la face intérieure de la partie de coopération (843), dont la longueur de la saillie est inférieure à celle de la saillie fixe (841), et une fine partie en plaque (844) de faible rigidité pour couvrir la monture de bornes (25), et
la monture (29) de tenue de couvercle présente une cavité (291) pouvant coopérer avec la saillie fixe (841) et une courte saillie (292) qui peut coopérer avec la saillie mobile (842),
de sorte que, si le couvercle (84) de monture de bornes doit être assujetti à la monture (29) de tenue de couvercle, la partie en plaque fine (844) est fléchie, la saillie fixe (841) est introduite dans la cavité (291), la partie de coopération (843) est enfoncée vers la monture (29) de tenue de couvercle, et la saillie mobile (844) est amenée en coopération avec la courte saillie (292).

8. Une structure de boîtier pour équipement électronique selon l'une des revendications précédentes, dans laquelle
il est prévu un programmateur (90) fixé au boîtier (10),
le programmateur (90) est sensiblement carré et présente quatre pattes de fixation (92-95) prévues sensiblement à ses quatre sommets, et des verrous prévus sur les faces latérales intérieures des pattes de fixation (92-95),
au moins deux connecteurs (96,97) sont prévus sur sa face sur laquelle les pattes de fixation (92-95) sont prévues, et
quatre cavités (15) sont formées dans la face supérieure du boîtier (10) en correspondance avec les quatre pattes de fixation (92-95),
de sorte que le programmateur (90) est assujetti au boîtier (10) dans la position horizontale ou verticale en amenant les pattes de fixation (92-95) en coopération avec les cavités (15) et l'un des connecteurs (96,97) est relié à un connecteur (55) de la carte à circuits imprimés (50) à travers un orifice de connecteur (19).

9. Une structure de boîtier pour équipement électronique selon la revendication 8, dans laquelle
les quatre pattes de fixation (92-95) sont sensiblement rectangulaires en section droite, les faces latérales intérieures de chaque patte de fixation sont en regard de celles des pattes adjacentes,
la première patte de fixation (92) comporte deux verrous (921,922) de forte rigidité sur ses faces latérales intérieures,
la deuxième patte de fixation (93) comporte sur ses faces latérales intérieures un verrou déplaçable (931) de faible rigidité et un verrou (932) de forte rigidité, le verrou déplaçable (931) de faible rigidité faisant face à l'un (921) des verrous de la première patte de fixation (92),
la troisième patte de fixation (94) comporte sur ses faces intérieures deux verrous déplaçables (941,942) de faible rigidité, le verrou déplaçable (942) étant en regard du verrou (932) de forte rigidité de la deuxième patte de fixation (93),
la quatrième patte de fixation (95) comporte sur ses faces latérales intérieures un verrou déplaçable (952) de faible rigidité et un verrou (951) de forte rigidité, le verrou déplaçable (952) de faible rigidité étant en regard de l'autre verrou (922) de la première patte de fixation (92), et le verrou de forte rigidité (951) étant en regard du verrou déplaçable (941) de faible rigidité de la troisième patte de fixation (94).

10. Une structure de boîtier pour équipement électronique selon la revendication 9, dans laquelle
la deuxième patte de fixation (93) présente une face de guidage (933) en alignement avec son verrou (932) de forte rigidité,
la troisième patte de fixation (94) comporte une première saillie de positionnement (943) formée sur une face parallèle à son verrou (942) et une seconde saillie de positionnement (944) formée sur une face parallèle à son autre verrou (941), et
la quatrième patte de fixation (95) présente une face de guidage (953) en alignement avec son verrou (951) de forte rigidité,
de sorte que, si le programmateur (90) doit être assujetti au boîtier (10) dans la position horizontale, la face de guidage (933) de la deuxième patte de fixation (93) agit comme guide, et la première saillie de positionnement (943) vient en coopération avec la cavité (15), et
si le programmateur (90) doit être assujetti au boîtier dans la position verticale, la face de guidage (953) de la quatrième patte de fixation (95) agit comme guide, et la seconde saillie de positionnement (944) vient en coopération avec la saillie (15).
